# EUROPEAN PATENT SPECIFICATION

(11) **EP 3 196 928 B1**
(45) Date of publication and mention of the grant of the patent: **04.09.2019**
(21) Application number: 15829203.7
(22) Date of filing: 31.07.2015
(51) Int. Cl.: H01L 23/488, H01L 23/36, H01L 23/34, H01L 23/40, H01L 23/48, B23K 35/30

(54) **METHOD FOR MANUFACTURING SUBSTRATE FOR POWER MODULE**
VERFAHREN ZUR HERSTELLUNG EINES SUBSTRATS FÜR LEISTUNGSMODULE
PROCÉDÉ DE FABRICATION D'UN SUBSTRAT DESTINÉ À UN MODULE D'ALIMENTATION

(30) Priority: 05.08.2014 JP 2014159337
(43) Date of publication of application: 26.07.2017
(73) Proprietor: Mitsubishi Materials Corporation, Tokyo 100-8117 (JP)
(72) Inventor: OOHIRAKI, Tomoya, Kitamoto-shi Saitama 364-0022 (JP); OI, Sotaro, Kitamoto-shi Saitama 364-0022 (JP)
(74) Representative: Hoffmann Eitle
(86) International application number: PCT/JP2015/071776
(87) International publication number: WO 2016/021491

(56) References cited:
- JP-A- 2001 044 312
- JP-A- 2002 353 351
- JP-A- 2002 353 351
- JP-A- 2007 088 365
- JP-A- 2008 311 295
- JP-A- 2008 311 295
- JP-A- 2013 197 185
- JP-A- 2013 229 579
- US-A- 5 247 862
- US-A1- 2005 118 447
- US-A1- 2007 164 766
- US-A1- 2008 098 788
- US-A1- 2014 192 486

## Description

### BACKGROUND OF THE INVENTION

### Field of the Invention

The present invention relates to a producing method of a power-module substrate used for a semiconductor device controlling large electric current and high voltage.

Priority is claimed on Japanese Patent Application No. 2014-159337, filed August 5, 2014, the content of which is incorporated herein by reference.

### Description of the Related Art

For an onboard power module, a power-module substrate in which metal plates are stacked on a ceramic substrate such as aluminum nitride or the like is used. The metal plates are respectively stacked on both surfaces of the ceramic substrate so that one is a circuit layer and the other is a heat-radiation layer. Generally, a copper plate or an aluminum plate is used for the circuit layer; and an aluminum plate is used for a heat-radiation layer.

For example, a circuit substrate having a ceramic substrate on which a copper plate is bonded on one surface and an aluminum plate is bonded on the other surface is disclosed in Japanese Unexamined Patent Application, First Publication No. 2003-197826 and Japanese Unexamined Patent Application, First Publication No. 2013-229579. In this case, the ceramic substrate and the copper plate are bonded by brazing material using Ag-Cu-Ti based active metal; and the ceramic substrate and the aluminum plate are bonded by Al-Si based brazing material.

This power-module substrate is produced as below. First, stacking a copper plate on one surface of a ceramic substrate with active-metal brazing material such as Ag-Cu-Ti suitable for bonding ceramics and the copper plate, and heating to temperature higher than melting the brazing material while pressing with a prescribed pressure, so that the ceramic substrate and the copper plate are bonded. Next, stacking an aluminum plate on the other surface of the ceramic substrate with Al-Si based brazing material suitable for bonding ceramics and the aluminum plate therebetween, and heating to temperature higher than melting the brazing material while pressing with a prescribed pressure, so that the ceramic substrate and the aluminum plate are bonded.

In this power-module substrate, a semiconductor chip which is a power element is mounted on the copper plate with soldering material therebetween.

Another example can be seen in document US 2007/164766 A1, which describes a circuit device having superior mechanical strength at the interface between a circuit board and a heat sink.

The circuit device includes the metal based insulation board for installing the circuit element and the heat sink, over which the insulation board is installed with a paste arranged in between. This document further discloses a producing method of a power substrate, wherein a metal plate is stacked on one surface of a ceramic substrate and bonded by brazing.

The metal surface is punched, burrs are formed acting as spacers, so that the bonding in between the heat sink and the substrate is equal, causing a uniform heat transfer.

### SUMMARY OF THE INVENTION

### Problems to be Solved by the Invention

In this power-module substrate, the active metal braze for bonding the copper plate and the ceramic substrate is provided as paste, and this braze paste and mother material of copper generates Ag-Cu melted braze. This melted braze may be exuded from between the copper plate and the ceramic substrate, and crawls up on a side surface of the copper plate. The melted braze crawling up on the surface may deteriorate appearance as stain, and also may deteriorate wettability of the soldering material used for bonding the semiconductor chip. Similarly for a case of using the aluminum plate as the circuit layer, a problem of the braze stain may be occurred by crawling up of the melted braze. If attempting to prevent the braze stain, bondability may be deteriorated.

The present invention is achieved in consideration of the above circumstances, and has an object to prevent a braze stain, and improve bondability of soldering a semiconductor chip without deteriorating bondability between a metal plate and a ceramic substrate.

### Means for Solving the Problem

When a metal plate is formed by press blanking, burrs are generated by a clearance of a pressing die. It was recognized that there is an effect of preventing the braze stain if the burrs are generated with prescribed height. In this case, a side in which the burrs are generated is a fracture surface having a rough surface. Accordingly, it is likely that if this fracture surface is close to the ceramic substrate, the melted braze is hard to crawl up the metal plate. Moreover, by a peripheral edge of the metal plates are strongly pressed by the burrs to the ceramic substrate, it is likely that the melted braze is prevented from exuding from bonding surfaces to an outside. It was found that the braze stain can be prevented without deteriorating the bondability by setting height of the burrs and thickness of the fracture surface.

A producing method of a power-module substrate according to the present invention is a producing method of a power-module substrate, in which a metal plate which is formed by blanking of a metal raw-plate by press working is stacked on one surface of a ceramic substrate and bonded by brazing, wherein the metal plate is a copper plate or an aluminum plate; the thicknesses of the copper plate and the aluminum plate being 0.1 mm to 10 mm; the copper plate being pressed at 0.05 MPa to 1.0 MPa, the aluminum plate being pressed at 0.3 MPa to 1.0 MPa; in which in the metal plate formed by blanking of the press working, a height of burrs by the blanking is set to be 0.021 mm or smaller and a thickness of a fracture surface is set to be 0.068 mm or larger, and the metal plate and the ceramic substrate are stacked so that a surface (i.e., a burr surface) of a side at which the burrs are generated is in contact with one surface of the ceramic substrate, and brazed with pressing these members in a stacking direction in a state in which the burrs are pressed to the ceramic substrate; the metal plate is cleaned before brazing; wherein for forming the metal plate by blanking by the press working, the metal plate is half-blanked out and then pushed-back, finally the metal plate is blanked; the half push-back amount being 0.18 to 0.22 mm.

In this case, if the height of the burrs exceeds 0.021 mm, a part of the melted braze may be exuded since the heights of the burrs vary widely, the bondability may be deteriorated since pressing force of bonding cannot be applied on whole surface. If the thickness of the fracture surface at a side surface of the metal plate is 0.068 mm or larger (at a dimension in a blanking direction), crawling up of the melted braze can be prevented since the fracture surface is rough even though the melted braze overflows. If the thickness of the fracture surface is smaller than 0.068 mm, it is difficult to prevent the braze stain.

The height of the burr is a maximum value obtained by measuring several points at the peripheral edge of the metal plate. The thickness of the fracture surface is a minimum value obtained by measuring several points at the side surface of the metal plate. As the fracture surface, a part is defined where an average height Rc of a rough curve element is 5 µm or larger.

In the producing method of the power-module substrate according to the present invention, it is desirable that, for forming the metal plate by blanking the metal raw-plate by the press working, the blanked metal plate is pushed-back into a blank hole of the metal raw-plate after blanking, then the metal plate is picked out from the blank hole.

Alternately, for forming the metal plate by blanking the metal raw-plate by the press working, it is applicable that the metal plate is half-blanked out from the metal raw-plate and then pushed-back into the metal raw-plate, finally the metal plate is blanked from the metal raw-plate.

By forming the metal plate by so-called push-back blanking, it is possible to control sizes of the burrs and the fracture surface more suitable comparing to a case in which the metal plate is formed by blanking in one direction. Accordingly, by suitably setting the half-blanking process and the push-back blanking, it is easy to control the height of the burr to be 0.021 mm or smaller and the thickness of the fracture surface to be 0.068 mm or larger.

In this case, for the push-back, the metal plate may be inserted, with whole thickness thereof or a part of the thickness, into the blanked-hole after entirely blanking. Moreover, the metal plate may be half-blanked by pressing the metal raw-plate till a half thickness thereof and then pushed back.

Either a copper plate and an aluminum plate may be used for the metal plate.

In a case in which the copper plate is used as the metal plate, it is bonded to the ceramic substrate by active-metal brazing material such as Ag-Ti, Ag-Cu-Ti or the like. In a case in which the aluminum plate is used as the metal plate, it is bonded by brazing material such as Al-Si- based brazing material.

### Effects of the Invention

According to the present invention, without deteriorating the bondability between the metal plate and the ceramic substrate, the melted braze is prevented from crawling up on the side surface of the metal plate, the braze stain is prevented, and the bondability of soldering a semiconductor chip mounted on the metal plate is improved.

### BRIEF DESCRIPTION OF THE DRAWING

[FIG. 1] It is a side view of a power-module substrate of an embodiment according to the present invention.
[FIG. 2] It is a sectional view showing a part of a forming process of a metal plate sequentially by the parts (a) to (c).
[FIG. 3] It is a sectional view schematically showing a stacked state when the metal plate is bonded on a ceramic substrate.
[FIG. 4] It is a side view showing an example of a pressing tool used for a producing method according to the present invention.

### DETAILED DESCRIPTION OF THE INVENTION

Below, an embodiment of the present invention will be explained referring drawings.

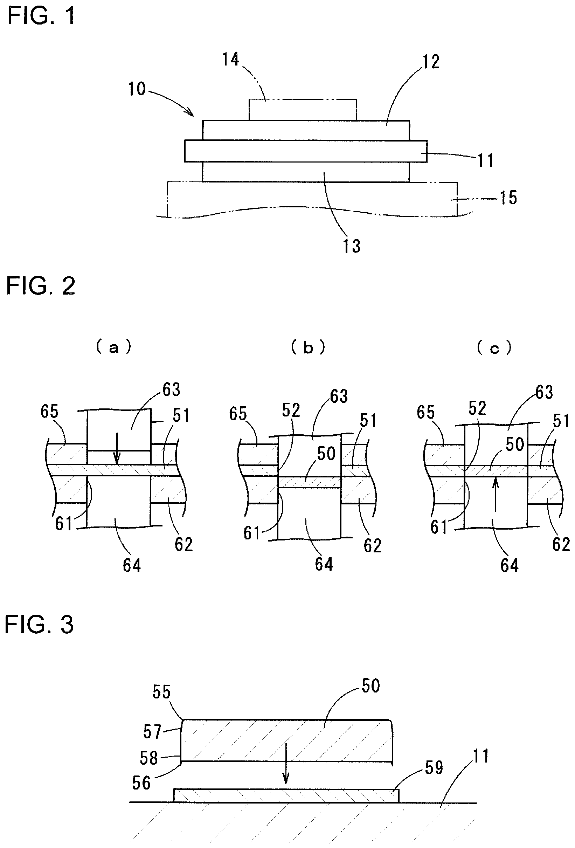

In a power-module substrate 10 as shown in FIG. 1, a copper plate (a metal plate ) 12 to be a circuit layer is stacked on one surface of a ceramic substrate 11 in a thickness direction, an aluminum plate (a metal plate) 13 to be a heat-radiation layer is stacked on the other surface of the ceramic substrate 11 in the thickness direction, and these are bonded by brazing material. A semiconductor chip 14 is mounted on a surface of the copper plate 12 by soldering. A heat sink 15 is bonded on the aluminum plate 13.

The ceramic substrate 11 is formed from aluminum nitride (AlN), alumina (Al₂O₃), silicon nitride (Si₃N₄) or the like into a thickness of 0.25 mm to 1.0 mm, for example. The copper plate 12 is formed from pure copper such as oxygen-free copper, tough-pitch copper or the like or copper alloy. The aluminum plate 13 is formed from pure aluminum with purity 99.00% or higher or aluminum alloy. Thicknesses of the copper plate 12 and the aluminum plate 13 are 0.1 mm to 10 mm, for example.

As a desirable example of a combination for the power-module substrate 10 of the present embodiment, for example, the ceramic substrate 11 is AlN with a thickness 0.635 mm, the copper plate 12 is a pure copper plate with a thickness 0.3 mm, and the aluminum plate 13 is a 4N-aluminum plate with a thickness 1.6 mm.

For bonding the ceramic substrate 11 and the copper plate 12, Ag-Ti based or Ag-Cu-Ti based active-metal brazing material is used; for example, brazing material of Ag-27.4 mass% Cu-2.0 mass% Ti. For bonding the ceramic substrate 11 and the aluminum plate 13, Al-Si based or Al-Ge based brazing material is used.

Below explained will be a producing method of the power-module substrate 10 by bonding the ceramic substrate 11, the copper plate 12, and the aluminum plate 13.

### <Metal Plate Forming Step>

The copper plate 12 and the aluminum plate 13 are blanking-formed by press working. These are made by the same process, so the copper plate 12 and the aluminum plate 13 are explained as metal plates 50 in this forming step.

Preparing a metal raw-plate 51 with a coil shape which can be made as the metal plates 50, the metal raw-plate 51 is sent intermittently into a press machine from the coil shape. In the press machine, as shown in a part (a) of FIG. 2, a die 62 having a forming hole 61 for forming the metal raw-plate 51 into the metal plate 50, a punch 63, and a push-back tool 64 fitted in the forming hole 61 of the die 62 are provided. In FIG. 2, the reference symbol 65 denotes a plate presser which presses the metal raw-plate on a surface of the die 62.

As shown in the part (a) of FIG. 2, the metal raw-plate 51 is sent between the die 62 and the punch 63, then the punch 63 moves downward so as to blank the metal raw-plate 51 as shown in a part (b) of FIG. 2 between an inner peripheral edge of the forming hole 61 of the die 62 while the push-back tool 64 in the forming hole 61 of the die 62 is pressed down. After blanking, the push-back tool 64 moves upward so as to follow an upward movement of the punch 63, and pushes back the metal plate 50 which is blanked as shown in a part (c) of FIG. 2 into a blank hole 52 of the original metal raw-plate 51. The metal raw-plate 51 after the blank hole 52 is formed is called a skeleton. At this time, as shown by an arrow in the part (c) of FIG. 2, the blanked metal plate 50 is pushed up in a counter direction to a blanking direction, shaving is occurred because an inner peripheral surface of the blank hole 52 of the metal raw-plate (the skeleton) 51 and an outer peripheral surface of the blanked metal plate 50 are scratched against each other. As a result, the burrs generated at the outer peripheral edge of the metal plate 50 by blanking are scraped by the inner peripheral surface of the blank hole 52 and decreased.

The metal plate 50 is pushed back to the blank hole 52 of the metal raw-plate (the skeleton) 51, and then extracted out from the blank hole 52.

By press working of the metal plate 50 as described above, at the peripheral edge part of one surface of the metal plate 50 becomes a drooped part 55; and burrs 56 are generated at the peripheral edge of the other surface. The side surface is a shear plane 57 with small surface roughness at the side of the drooped part 55, and is a fracture surface 58 with large surface roughness at the side of the burrs 56 are generated. In this metal plate 50, heights of the burrs 56 measured at several points of the peripheral edge of the metal plate 50 are 0.021 mm or smaller; and thicknesses (dimension in the blanking direction) of the fracture surface 58 are 0.068 mm or larger.

When the metal plate 50 is blanked from the metal raw-plate 51, as shown in the part (b) of FIG. 2, the punch 63 may be inserted at a tip end thereof into the forming hole 61 of the die 62 and moved downward until the metal plate 50 is quite separated from the metal raw-plate 51. It is also possible that the metal plate 50 is cut from the metal raw-plate 51 although the downward movement of the punch 63 is stopped at a stage in which the tip end of the punch 63 does not reach to an opening end of the forming hole 61 of the die 62 (i.e., a half-blanking state) since the punch 63 cuts into the metal raw-plate 51 at a most part in plate thickness: furthermore, the punch 63 may be pushed back from that state.

### <Copper Plate Bonding Step>

The copper plate 12 among the metal plates 50 which are made by the metal plate forming step is stacked on one surface of the ceramic substrate 11 with active-metal brazing material made of paste or a foil therebetween. At this time, the surface at the side in which the burrs 56 are generated in the metal plate forming step is stacked onto the surface of the ceramic substrate 11. FIG. 3 schematically shows a previously described state in which the metal plate 50 is stacked on the ceramic substrate 11. The metal plate 50 is stacked so as to stack the surface in which the burrs 56 are generated onto a brazing material layer 59 of the ceramic substrate 11, so that a stacked body 40 of the ceramic substrate 11, the brazing material layer 59 and the copper plate 12 is formed.

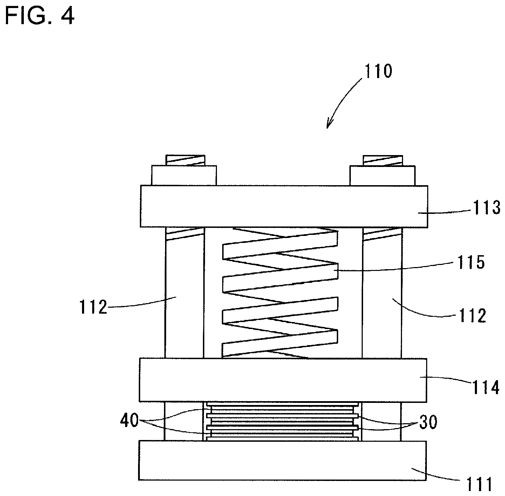

Then, the stacked bodies 40 are stacked respectively between cushion sheets 30 which are carbon graphite plate or the like, and pressed in a stacking direction with 0.05 MPa to 1.0 MPa for example, by a pressing tool 110 as shown in FIG. 4.

The pressing tool 110 is provided with a base plate 111, guide posts 112 which are vertically fixed at four corners of an upper surface of the base plate 111, a fix plate 113 which is fixed at top ends of the guide posts 112, a press plate 114 which is held by the guide posts 112 movably up and down between the base plate 111 and the fix plate 113, and a biasing means 115 such as a spring or the like, which is provided between the fix plate 113 and the press plate 114 so as to bias the press plate 114 downward. In this pressing tool 110, the above-mentioned stacked bodies 40 are arranged between the base plate 111 and the press plate 114.

In a state in which the stacked bodies 40 are pressed in the pressing tool 110, the pressing tool 110 is arranged in a heating furnace (not illustrated) and heated in vacuum atmosphere at temperature 800°C or higher and 930°C or lower for 1 minute to 60 minutes so as to braze the ceramic substrate 11 and the copper plate 12.

Braze between the ceramic substrate 11 and the copper plate 12 uses the active-metal brazing material. Ti that is active metal in the brazing material is dispersed early into the ceramic substrate 11 and makes TiN; and the copper plate 12 and the ceramic substrate 11 are bonded with Ag-Cu alloy.

### <Aluminum Plate Bonding Step>

After bonding the copper plate 12 on the ceramic substrate 11, a counter surface to the surface on which the copper plate is bonded is cleaned by pickling or the like if necessary: then the aluminum plate 13 made by the aforementioned metal plate forming step is stacked on the counter surface to the copper plate with brazing material therebetween. Stacked bodies of the ceramic plate 11 on which the copper plate 12 is bonded, the brazing material and the aluminum plate 13 are stacked respectively between the cushion sheets 30; and pressed in the stacking direction at 0.3 MPa to 1.0 MPa for example by the pressing tool 110. Also at this time, the aluminum plate 13 (the metal plate 50) is stacked on the ceramic substrate 11 so that the surface at the side at which the burrs 56 are generated is in contact with the ceramic substrate 11.

In this state in which the stacked bodies are pressed in the pressing tool 110, the pressing tool 110 is arranged in the heating furnace (not illustrated) and heated in vacuum atmosphere at temperature 630°C or higher and 650°C or lower for 1 minute to 60 minutes so as to braze the ceramic substrate 11 and the aluminum plate 13.

In the power-module substrate 10 manufactured as above, the copper plate 12 and the aluminum plate 13 are bonded so that the surfaces at which the burrs 56 are generated are in contact with the ceramic substrate 11; in the respective bonding steps, the burrs 56 are strongly pressed and the brazing material which is the bonding material is prevented by the burrs 56 from exuding from bonding boundary to an outside when melted. Although a part of melted braze is exuded to the outside, since the fracture surfaces 58 of the copper plate 12 and the aluminum plate 13 by cut from the metal raw-plates 51 are in contact with the surfaces of the ceramic substrate 11 respectively, the melted braze is prevented from crawling up on the fracture surfaces 58. Accordingly, it is possible to prevent the braze stain on the surfaces of the counter side to the bonding surfaces of copper plate 12 and the aluminum plate 13.

Therefore, since the braze stain is suppressed particularly on the surface of the copper plate 12 to be a circuit layer, it is possible to improve the solder bondability of the semiconductor chip 14 mounted on the cupper plate 12. In addition, the height of the burrs 56 is kept at 0.021 mm or smaller, so that the bondability of the ceramic substrate 11 to the copper plate 12 and the aluminum plate 13 is not deteriorated.

### Examples

Next, a confirmation test performed for confirming effects of the present invention will be explained.

Used as a ceramic substrate was an aluminum nitride plate with a rectangle shape of 30 mm × 30 mm and a thickness 0.635 mm. A copper plate with a rectangle shape of 27 mm × 27 mm and a thickness 0.3 mm was used as a metal plate (a copper plate) blanked by a press working on the metal raw-plate (an oxygen-free copper plate). As for the copper plate, as shown in Table 1, test pieces were made by push-back blanking in which the plate was half blanked and then pushed back; and test pieces were made by blanking in which the plate was blanked in one press working without pushing back. Half push-back amounts of the push back (push amounts of the punch to the metal raw-plate) in the respective Examples and Comparative Examples are shown in Table 1.

Regarding the blanked copper plate, observing configurations at side surfaces and measuring a minimum thickness of fracture surfaces by a laser microscope, average values were calculated from five test pieces with regard to Examples and Comparative Examples. Observing a surface of the copper plate, measuring a maximum height of burrs by the laser microscope, so that average values were calculated from five test pieces respectively.

A brazing material layer of Ag-8.8 mass% Ti was formed on a surface of the aluminum nitride plate. The brazing material was formed so that whole circumference thereof was 0.2 mm larger than the copper plate. The copper plate was stacked on the aluminum nitride plate so that the side in which the burrs were generated was in contact with the brazing material layer on the aluminum nitride plate; and these members were held for 30 minutes at 830°C while pressing with pressure of 1 kgf/cm² (about 0.1 MPa).

Here, the braze stain is generated by solidified Ag-Cu melted liquid phase crawling from a bonding boundary along the side surface to the surface of the copper plate, and cannot be measured as unevenness of the surface because a thickness thereof is smaller than 5 µm. Accordingly, the braze stain was regarded if a stain was recognized by the naked eye to have a width thereof from a periphery of the copper plate was 1 mm or larger. If an incidence of the braze stain was 0%, it was evaluated as "good": or it was evaluated as "not good" if even a little braze stain was recognized.

Regarding bondability between the copper plate and the ceramic plate, an area of void (vacancy) at the bonding boundary was measured by observing the bonding boundary between the copper plate and the ceramic plate by an ultrasonic image measuring device: and a void rate was calculated as a total area of the void with regards to an area to be bonded (an area of the copper plate). If the void rate was smaller than 2% it was evaluated as "good": or it was evaluated as "not good" if the void rate exceeds 2%.

These results are shown in Table 1.

**[Table 1]**

| | Press Method | Half Push-back Amaount | Thickness of Fracture Surface | Maximum Height of Burrs | Braze Stain | Bondavility |
|---|---|---|---|---|---|---|
| Example 1 | Push Back | 0.22mm | 0.068mm | 0.011mm | Good | Good |
| Example 2 | Push Back | 0.20mm | 0.089mm | 0.013mm | Good | Good |
| Example 3 | Push Back | 0.18mm | 0.110mm | 0.021mm | Good | Good |
| Comparative Example 1 | Single Stroke | - | 0.118mm | 0.051mm | Good | Not Good |
| Comparative Example 2 | Push Back | 0.24mm | 0.047mm | 0.009mm | Not Good | Good |

It is clear from Table 1 that the bondability was good when the height of the burrs of the copper plate was 0.021 mm or larger; and the braze stain was prevented when the thickness of the fracture surface was 0.068 mm or larger.

The present invention is not limited to the above-described embodiments and various modifications may be made without departing from the scope of the present invention.

In the above embodiment, the circuit layer was the copper plate and the heat-radiation layer was the aluminum plate: however, it is not limited to this combination. Both the circuit layer and the heat-radiation layer can be the same kind of metal plates, e.g., aluminum plates. In this case, it is possible to bond the metal plates on both surfaces of the ceramic substrate by single bonding step.

### Industrial Applicability

Without deteriorating the bondability between the metal plate and the ceramic substrate, the braze stain is prevented and the solder bondability of the semiconductor chip is improved.

### Reference Symbols

- 10: power-module substrate
- 11: ceramic substrate
- 12: copper plate (metal plate)
- 13: aluminum plate (metal plate)
- 14: semiconductor chip
- 15: heat sink
- 40: stacked body
- 30: cushion sheet
- 50: 50
- 51: metal raw-plate
- 52: blank hole
- 55: drooped part
- 56: burr
- 57: shear plane
- 58: fracture surface
- 59: brazing material layer
- 61: forming hole
- 62: die
- 63: punch
- 64: push-back tool
- 65: plate presser
- 110: pressing tool
- 111: base plate
- 112: guide post
- 113: fix plate
- 114: press plate
- 115: biasing means

## Claims

1. A producing method of a power-module substrate (10), wherein a metal plate (50) which is formed by blanking of press working is stacked on one surface of a ceramic substrate (11) and bonded by brazing, wherein the metal plate is a copper plate (12) or an aluminum plate (13); the thicknesses of the copper plate (12) and the aluminum plate (13) being 0.1 mm to 10 mm; the copper plate (12) being pressed at 0.05 MPa to 1.0 MPa, the aluminum plate (13) being pressed at 0.3 MPa to 1.0 MPa; wherein
in the metal plate (50) formed by blanking of the press working, a height of burrs (56) thereof is set to be 0.021 mm or less and a thickness of a fracture surface thereof is set to be 0.068 mm or more, and
the metal plate (50) and the ceramic substrate (11) are stacked so that a surface of a side at which the burrs (56) are generated is in contact with the one surface of the ceramic substrate (11) with a brazing material therebetween, and brazed with pressing these members in a stacking direction in a state in which the burrs (56) are pressed to the ceramic substrate (11); the metal plate is cleaned before brazing; wherein for forming the metal plate (50) by blanking by the press working, the metal plate (50) is half-blanked out and then pushed-back, finally the metal plate (50) is blanked; the half push-back amount being 0.18 to 0.22 mm.

## Patentansprüche

1. Herstellungsverfahren für ein Strommodulsubstrat (10), wobei eine Metallplatte (50), die durch Stanzen einer Pressbearbeitung gebildet wird, auf eine Oberfläche eines Keramiksubstrats (11) gestapelt und durch Löten verbunden wird, wobei die Metallplatte eine Kupferplatte (12) oder eine Aluminiumplatte (13) ist; wobei die Dicken der Kupferplatte (12) und der Aluminiumplatte (13) 0,1 mm bis 10 mm betragen; die Kupferplatte (12) mit 0,05 MPa bis 1,0 MPa gepresst wird, die Aluminiumplatte (13) mit 0,3 MPa bis 1,0 MPa gepresst wird; wobei
in der Metallplatte (50), die durch Stanzen der Pressbearbeitung gebildet wird, eine Höhe von Graten (56) davon auf 0,021 mm oder weniger und eine Dicke einer Bruchfläche davon auf 0,068 mm oder mehr eingestellt wird, und
die Metallplatte (50) und das Keramiksubstrat (11) gestapelt sind, sodass eine Oberfläche einer Seite, an der die Grate (56) erzeugt werden, in Kontakt mit der einen Oberfläche des Keramiksubstrats (11) mit einem dazwischen befindlichen Hartlotmaterial steht und durch Pressen dieser Elemente in einer Stapelrichtung in einem Zustand gelötet wird, in dem die Grate (56) auf das Keramiksubstrat (11) gepresst werden; wobei die Metallplatte vor dem Löten gereinigt wird; wobei zum Formen der Metallplatte (50) durch Stanzen durch die Pressbearbeitung die Metallplatte (50) zur Hälfte ausgestanzt und dann zurückgeschoben wird, und die Metallplatte (50) schließlich ausgestanzt wird; wobei der halbe Rückschiebebetrag 0,18 bis 0,22 mm beträgt.

## Revendications

1. Procédé de production d'un substrat de module de puissance (10), dans lequel une plaque métallique (50) qui est formée en découpant le travail de presse est empilée sur une surface d'un substrat en céramique (11) et adhérée par brasage, dans lequel la plaque métallique est une plaque en cuivre (12) ou une plaque en aluminium (13) ; les épaisseurs de la plaque en cuivre (12) et de la plaque en aluminium (13) étant de 0,1 mm à 10 mm ; la plaque en cuivre (12) étant pressée à entre 0,05 MPa et 1,0 MPa, la plaque en aluminium (13) étant pressée à entre 0,3 MPa et 1,0 MPa ; dans lequel
dans la plaque métallique (50) formée en découpant le travail de presse, une hauteur de bavures (56) de celle-ci est définie pour être de 0,021 mm ou moins et une épaisseur d'une surface de rupture de celle-ci est définie pour être de 0,068 mm ou plus, et
la plaque métallique (50) et le substrat en céramique (11) sont empilés de sorte qu'une surface d'un côté sur lequel les bavures (56) sont générées soit en contact avec l'une surface du substrat en céramique (11) avec un matériau de brasage entre celles-ci, et brasée en pressant ces éléments dans une direction d'empilement dans un état dans lequel les bavures (56) sont pressées sur le substrat en céramique (11) ; la plaque métallique est nettoyée avant le brasage ; dans lequel, pour former la plaque métallique (50) en découpant par le travail de presse, la plaque métallique (50) est à moitié découpée et ensuite repoussée, enfin la plaque métallique (50) est découpée ; la quantité de repoussage à moitié étant de 0,18 à 0,22 mm.
